# EUROPEAN PATENT APPLICATION

(11) **EP 1 126 321 A1**
(43) Date of publication of application: **22.08.2001**
(21) Application number: 01301054.1
(22) Date of filing: 06.02.2001
(51) Int. Cl.: G03F 7/039, G03F 7/004, C08F 212/14, C08F 8/00

(54) **Positive photoresists containing crosslinked polymers**

(30) Priority: 10.02.2000 US 181585 P
(71) Applicant: Shipley Company LLC, Marlborough, MA 01752 (US)
(72) Inventor: Adams, Timothy G., Sudbury, Massachusetts 01776 (US); Rajaratnam, Martha M., Ridgefield, Connecticut 06877 (US); Pandya, Ashish A., Natick, Massachusetts 01760 (US); Sinta, Roger F., Woburn, Massachusetts 01801 (US); Varanasi, Pushkara R., Poughkeepsie, New York 12603 (US); Cornett, Kathleen, Wappingers Falls, New York 12590 (US); Katnani, Ahmad D., Poughkeepsie, New York 12603 (US)
(74) Representative: Buckley, Guy Julian

(57) **Abstract**

The invention provides novel cross-linked polymers and positive chemically-amplified photoresist compositions that comprise a photoactive component and such cross-linked polymers. Resists of the invention can exhibit enhanced lithographic results relative to comparable compositions where the polymers are not crosslinked.

## Description

### BACKGROUND OF THE INVENTION

### 1. Field of the Invention

The present invention relates to new polymers and use of such polymers as a resin binder component for positive-acting photoresist compositions. More particularly, resists of the invention contain polymers that are crosslinked prior to imaging or other lithographic processing.

### 2. Background

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble.

More recently, chemically-amplified-type resists have been increasingly employed, particularly for formation of sub-micron images and other high performance applications. Such photoresists may be negative-acting or positive-acting and generally include many crosslinking events (in the case of a negative-acting resist) or deprotection reactions (in the case of a positive-acting resist) per unit of photogenerated acid, In the case of positive chemically-amplified resists, certain cationic photo-initiators have been used to induce cleavage of certain "blocking" groups pendant from a photoresist binder, or cleavage of certain groups that comprise a photoresist binder backbone. See, for example, U.S. Patents Nos. 5,075,199; 4,968,581; 4,883,740; 4,810,613; and 4,491,628, and Canadian Patent Application 2,001,384. Upon cleavage of the blocking group through exposure of a coating layer of such a resist, a polar functional group is formed, e.g., carboxyl or imide, which results in different solubility characteristics in exposed and unexposed areas of the resist coating layer. See also R.D. Allen et al., *Proceedings of SPIE*, 2724:334-343 (1996); and P. Trefonas et al. *Proceedings of the 11*^{*th*} *International Conference on Photopolymers (Soc*. *Of Plastics Engineers)*, pp 44-58 (Oct. 6, 1997).

### SUMMARY OF THE INVENTION

The invention provides novel polymers and chemically-amplified positive photoresist compositions that contain such polymers. Polymers of the invention are at least partially crosslinked and contain non-aromatic units that can deblock in the presence of photoacid. Resists of the invention in general contain a photoactive component and one or more such acid labile polymers that are crosslinked upon formulation of the resist, i.e. resists of the invention contain polymers that are crosslinked prior to exposure to patterned radiation or other lithographic processing.

We have surprisingly found that resists of the invention can exhibit enhanced lithographic results relative to comparable compositions where the polymers are not crosslinked. In particular, significantly enhanced contrast (dissolution rate differentials) between exposed and unexposed regions of a resist coating layer of the invention can be achieved with only moderate levels of pre-exposure crosslinking. For example, about 5 or 10 mole percent of reactive polymer units can be crosslinked to provide such enhanced lithographic results. See, for instance, the results set forth in the examples which follow.

Resists of the invention can include a variety of units, including aromatic groups e.g. phenolic groups. The acid labile groups preferably do not contain a phenyl or other aromatic moiety. Acrylate photoacid labile groups are particularly preferred. Copolymers that contain phenolic and acrylate groups are particularly preferred, such as copolymers formed by polymerization of 1) hydroxystyrene and 2) an acrylate with a photoacid labile ester such as t-butyl acrylate, t-butyl methacrylate and the like. Higher order copolymers are also preferred such as terpolymers, e.g. as provided by polymerization of 1) hydroxystyrene, 2) styrene and 3) units that contain a photoacid labile group such as the above-mentioned alkylester acrylates.

Polymers of the invention also may be substantially, essentially or completely free of phenyl or other aromatic groups, particularly for short wavelength imaging applications, such as 193 nm, 157 nm and other sub-200 nm wavelength exposures where aromatic groups can absorb excessive exposure radiation. Preferably such polymers have less than about 5 mole percent aromatic groups, based on the total polymer, more preferably less than about 3, 2, 1, 0.5, or 0.1 mole percent aromatic groups. Particularly preferred polymers for such short wavelength imaging will be completely free of aromatic groups.

References herein to "crosslinking" or other similar term are intended to refer to essentially any covalent linkage between polymer chains or sites.

The invention also provides methods for forming relief images, including methods for forming a highly resolved relief image such as a pattern of lines where each line has essentially vertical sidewalls and a line width of about 0.40 microns or less, or even about 0.25 microns or less. The invention further provides articles of manufacture comprising substrates such as a microelectronic wafer or a liquid crystal display or other flat panel display substrate having coated thereon the photoresists and relief images of the invention. Other aspects of the invention arc disclosed infra.

### DETAILED DESCRIPTION OF THE INVENTION

Polymers of the invention contain one or more functional groups that can provide crosslinking between polymer chains or sites. For instance, polymers of the invention may include one or more groups, in cross-linked form, of alcohols, aldehydes, esters, alkenyl groups, ketones, amines, thiols, sulfides and the like to enable crosslinking between polymer chains. Those groups in crosslinked form should be clear to those skilled in the art. For example, hydroxy groups may be present as ethers, esters or the like. Sulfides may be present as thioethers. Amines may be present as higher order amines, e.g. as a tertiary amine.

Crosslinking may be provided by direct linking of two polymer sites or chains, or by use of a separate crosslinking component that can link multiple polymer sites or chains.

For instance, suitable crosslinker components include homo- and heterobifunctional crosslinking agents, such as unsaturated compounds e.g. aldehydes and other carbonyl compounds, and compounds containing one or more carbon-carbon double bonds. The linked crosslinking component also may contain a photoacid labile moiety that may be deblocked to provide solubility differentials between exposed and unexposed resist areas. More particularly, preferred crosslinker components include vinyl ethers and bis-maleimide compounds. Specifically preferred are vinyl ether compounds, particularly bis-vinyl ether cross-linkers such as 1,4-butanedivinyl ether, 1,6-hexanedivinyl ether, 1,4-cyclohexane dimethanoldivinyl ether, bis-vinylether-ethane ether and the like. Such vinyl ethers are suitably employed to link polymers that have hydroxy or carboxy moieties, such as polymers that contain phenolic units.

As discussed above, polymers of the invention also include units that undergo reaction in the presence of photogenerated acid, particularly a cleavage reaction to provide polar moieties such as carboxy (COOH). Such acid labile groups are suitably pendant to the polymer backbone. Such photoacid-labile units also may be a component of the intramolecular or intermolecular crosslinked position of polymer(s) of a resist of the invention. Acrylate groups are generally preferred and can be formed by free radical or other condensation of monomers of one or more substituted or unsubstituted alkyl acrylates such as *t*-butylacrylate and *t*-butylmethacrylate. Acrylacetate groups are also generally preferred and can be formed by free radical or other condensation of monomers of one or more substituted or unsubstituted alkyl acrylates such as *t*-butylacrylacetate, *t*-butylacryloxyacetate and *t*-butylmethacryloxyacetate. Suitable monomers are commercially available or can be readily prepared by known procedures. The pendant substituted ester moiety of the condensed acrylate unit, i.e. R-O-C(=O)-, serves as the pendant acid labile groups. A wide variety of acrylate units may be employed including those having an ester group (group R above) that is a non-cyclic or cyclic alkyl having 1 to about 14 carbon atoms, more typically 1 to about 8 carbons. Preferably the group R may be a tertiary non-cyclic alkyl such as t-butyl, or a second or tertiary alicyclic group such as adamantyl including 2-methyladamantyl, isobornyl, norbornyl and the like. Also suitable will be such alkyl ester groups that have one or more substituents such as halogen, particularly F, Cl or Br, C₁₋₆ alkoxy, aryl such as phenyl, etc. Exemplary compounds that may be condensed to provide acrylate units of the polymers of the invention include butylacryloxyacetate including *t*-butylacryloxyacetate, butylmethacryloxyacetate including *t*-butylmethacryloxyacetate, etc. Suitable acrylate acid-labile groups also include those of the formula R³O(C=O)R²R¹C- where R¹ and R² are each independently selected from the group of hydrogen, substituted or unsubstituted C₁₋₁₀ alkyl, substituted or unsubstituted alkyloxyacetate or an electron-withdrawing group such as halogen; and R³ is substituted or unsubstituted C₁₋₁₄ alkyl, substituted or unsubstituted aryl such as phenyl or substituted or unsubstituted aryalkyl such as benzyl. The substituents of substituted groups can be, e.g., halogen, C₁₋₆ alkyl, C₁₋₆ alkoxy, phenyl or other aryl, etc. Such acetate groups may be provided as described above for acrylate groups, i.e., by free radical or other condensation of monomers of one or more substituted or unsubstituted vinyl acetates such as allyl acetate and the like, Other suitable acid labile groups include those disclosed e.g. in U.S. Patent Nos. 5,362,600; 4,968,581; 4,883,740;

Polymers of the invention may comprise units in addition to crosslinked groups and acid labile groups. For example, polymers of the invention may contain units that may be reactive to crosslinking, but arc present without linkage to other polymer chains. For instance, a polymer of the invention may contain phenolic units such as may be provided by reaction of hydroxystyrene or hydroxy(α-methyl)styrene, acid units such as may be provided by reaction of acrylic acid, methacrylic acid, and the like. Polymers of the invention also may suitably contain units that are essentially unreactive under typical lithographic conditions (photoacid and temperatures of about up to 180°C for no more than about 60 seconds) such as phenyl groups that may be provided by reaction of styrene, and alkyl and alicyclic groups such as may be provided by various vinyl monomers e.g. vinyl norborene and the like. Other preferred polymer units include nitrile units such as may be provided by reaction of acrylonitrile and methacrylonitrile.

Preferred polymers of the invention include phenolic polymers that contain units of 1) phenol or crosslinked phenol; 2) photoacid labile groups that preferably do not contain a phenyl or other aromatic moiety, particularly acrylate esters; and optionally 3) other groups including those that are essentially unreactive under typical lithographic processing conditions (e.g. temperatures to 180°C for 60 seconds and photoacid), such as nitrile groups; alicyclic and non-cyclic alkyl groups such as adamantyl, norbornyl, isobornyl and the like, each optionally substituted with C₁₋₆ alkyl and the like; styrene groups or styrene substituted with unreactive groups such as halogen, C₁₋₈ alkyl, C₁₋₈ alkoxy, C₁₋₈ alkylsulfonyl e.g. mesyl, arylsulfonyl particularly carbocyclic arylsulfonyl such as tosyl and the like.

In such phenolic copolymers, preferably the polymer will contain from about 40 to 90 mole percent of phenolic units or crosslinked phenolic units 1), more preferably from about 50 to 75 or 80 mole percent of phenolic or crosslinked units 1); from about 4 or 5 to about 40 mole percent of acid labile units, more preferably from about 5 or 10 to 15, 20, 25, 30, 35 or 40 mole percent or acid labile units 2); and from 0 to 40 mole percent of optional units 3), more typically 0 to about 10, 15, 20, 25, or 30 mole percent of units 3).

References herein to "optionally substituted" moieties or "substituted" moieties indicate that the specified group may be substituted with a relatively wide variety of non-hydrogen groups such as halogen (particularly F, Cl or Br), C₁₋₈ alkyl, C₁₋₈ alkoxy, aryl particularly carbocyclic aryl such as phenyl, nitro, cyano, C₁₋₈alkylsulfonyl such as mesyl and the like.

Polymers of the invention can be prepared e.g. by free radical polymerization, e.g. by reaction of a plurality of monomers to provide the various units as discussed above in the presence of a radical initiator under an inert atmosphere (e.g., N₂ or argon) and at elevated temperatures such as about 70° C or greater, although reaction temperatures may vary depending on the reactivity of the particular reagents employed and the boiling point of the reaction solvent (if a solvent is employed). See the examples which follow for exemplary reactions conditions. Suitable reaction temperatures for any particular system can be readily determined empirically by those skilled in the art based on the present disclosure.

A reaction solvent may be employed if desired. Suitable solvents include propyleneglycol monomethylether acetate (PMA), or alcohols such as propanols and butanols as well as aromatic solvents such as benzene, chlorobenzene, toluene and xylene. Dimethyl sulfoxide and dimethylformamide are also suitable. The polymerization reaction also may be run neat.

A variety of free radical initiators may be employed to prepare the copolymers of the invention. For example, azo compounds may be employed such as azo-bis-2,2'-isobutyronitrile (AIBN) and 1,1'-azo-bis(cyclohexanecarbonitrile). Peroxides, peresters, peracids and persulfates also can be employed.

Monomers that contain hydroxy (such as para-hydroxystyrene) or other reactive moieties may be condensed in "masked" form if desired to facilitate polymer synthesis. For example para-acetoxystyrene may be employed as a "masked" form of parahydroxystyrene. Other hydroxy masking or protecting groups also will be suitable such as alkylsilyl groups (to form silylethers with the hydroxy moiety), e.g. (CH₃)₃Si-, (CH₃)₂(butyl)Si-, ((CH₃)₃C)₃Si-, etc.; other alkyl esters, e.g. CH₃CH₂C(=O)-, etc. After reaction completion, the masking groups may be removed under basic conditions. For example, the formed polymer may be heated in the presence of a base such as NH₄OH or NH₄OAc.

Crosslinking of polymers of the invention can be accomplished by a variety of methods, which may suitably vary with the crosslinking component and reactive functionalities employed in a particular system. In one preferred approach, preformed polymers are reacted with a crosslinking agent to thereby link the polymer chains. The amount of crosslinker employed and reaction conditions can be controlled to provide crosslinking at a targeted level. More particularly, a divinyl ether compound such as those mentioned above can be admixed with polymers having photoacid labile groups and reactive groups such as hydroxy (e.g. a polymer having phenolic units), carboxy (e.g. acrylic or methacrylic acid units) and the like to thereby crosslink the polymers. The reaction can be conducted under mild conditions (e.g. room temperature) in the presence of a weak acid that will promote crosslinking of the polymer chains, but without deblocking of the polymer photoacid labile groups. The reaction may be conducted in a suitable solvent such as a propylene glycol alkyl ether, a lactate such as ethyl lactate, and the like. The crosslinked product also may be directly formulated in that reaction solvent into a photoresist formulation by addition of a suitable photoactive component, e.g. a photoacid generator as discussed below.

As mentioned, good lithographic results have been achieved with only quite moderate levels of crosslinking available polymer sites. For instance, suitably no more than about 20, 25, or 30 mole percent of reactive polymer groups may be crosslinked, more typically no more than about 5, 10 or 15 mole percent of reactive polymer groups may be crosslinked. Even lower levels of crosslinking can be employed, e.g. about 0.5, 1, 2, 3 or 4 mole percent of available reactive polymer groups may be crosslinked.

Crosslinking suitably may be either intermolecular, i.e. linking of separate polymer chains, or intramolecular, i.e. linking of groups within a single polymer chain. The extent of intermolecular or intramolecular crosslinking can be controlled by use of appropriate reaction conditions, e.g. by conducting the crosslinking reaction with a high concentration of polymer in solvent and slow addition of the crosslinker component to promote intermolecular crosslinking, or by conducting the crosslinking reaction with the polymer quite dilute in a reaction solvent to promote intramolecular crosslinking.

Generally preferred copolymers of the invention may have a weight average molecular weight (Mw) of 1,000 to about 100,000, more preferably about 2,000 to about 30,000 with a molecular weight distribution (Mw/Mn) of about 3 or less, more preferably a molecular weight distribution of about 2 or less. Molecular weights (either Mw or Mn) of the polymers of the invention are suitably determined by gel permcation chromatography. Suitable molecular weight distributions of copolymers of the invention include from about I to 5, more typically from about 1 to 3 or 4.

As discussed above, the invention also includes chemically amplified positive-acting photoresists. The resists of the invention in general comprise a photoactive component and a polymer of the invention that is linked to other polymer chains and contains photoacid labile groups. Photoactivation of a coating layer of the resist results in a cleavage or other reaction of the polymer acid labile groups. The polymer component should be used in an amount sufficient to render a coating layer of the resist developable with an aqueous alkaline developer.

The photoactive compounds typically includes a photoacid generator (i.e. "PAG") that is suitably employed in an amount sufficient to generate a latent image in a coating layer of the resist upon exposure to activating radiation.

One group of preferred PAGs for use in the resists of the invention include imidosulfonates such as compounds of the following formula: 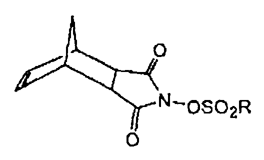 wherein R is camphor, adamantane, alkyl (e.g. C₁₋₁₂ alkyl) and perfluoroalkyl such as perfluoro(C₁₋₁₂alkyl), particularly perfluoro anions of perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds arc also may be employed such as sulfonate salts. Two suitable agents are the following PAGs 1 and 2:

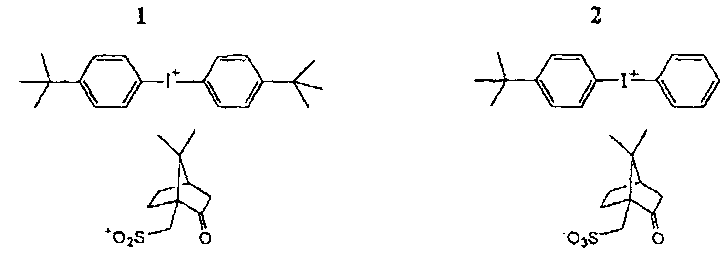

Such sulfonate compounds can be prepared as disclosed in European Patent Application 96118111.2 (publication number 0783136).

Also suitable are the above two iodonium compounds complexed with anions other than the above-depicted groups. In particular, preferred anions include those of the formula RSO₃⁻ where R is adamantane, alkyl (e.g. C₁₋₁₂ alkyl) and perfluoroalkyl such as perfluoro (C₁₋₁₂ alkyl), particularly perfluoro counter anions of perfluorooctanesulfonate, perfluorononanesulfonate and the like.

Other known PAGs also may be employed in the resists of the invention. For example, N-sulfonyloxyimides may be employed such as those described in International application WO94/10608, or non-ionic halogenated PAGs that generate a halogen acid (e.g. HBr) upon exposure to activating radiation as described e.g. in U.S. Patent 5,128,232 to Thackeray et al. and in European Patent Application Nos. 0164248 and 0232972.

A preferred optional component of resist compositions of the invention is a dye compound. Preferred dyes can enhance resolution of the patterned resist image, typically by reducing reflections and the effects thereof (e.g. notching) of the exposure radiation. Preferred dyes include substituted and unsubstituted phenothiazinc, phenoxazine, anthracene and anthrarobin compounds. Preferred substituents of substituted phenothiazine, phenoxazine, anthracene and anthrarobin include e.g. halogen, C₁₋₁₂alkyl, C₁₋₁₂ alkoxy, C₂₋₁₂ alkenyl, C₁₋₁₂ alkanoyl such as acctyl, aryl such as phenyl, etc. Copolymers of such compounds also may be used as a dye, e.g. an anthracene acrylate polymer or copolymer.

Another preferred optional additive is an added base, particularly tetrabutylammonium hydroxide (TBAH), or a lactate salt of TBAH, which can enhance resolution of a developed resist relief image. The added base used in relatively small amounts, e.g. about 1 to 20 percent by weight relative to the photoactive component (PAG).

Photoresists of the invention also may contain other optional materials. For example, other optional additives include anti-striation agents, plasticizers, speed enhancers, etc. Such optional additives typically will be present in minor concentrations in a photoresist composition except for fillers and dyes which may be present in relatively large concentrations such as, e.g. in amounts of from about 5 to 30 percent by weight of the total weight of a resist's dry components.

The compositions of the invention can be readily prepared by those skilled in the art. For example, a photoresist composition of the invention can be prepared by admixing the components of the photoresist in a suitable solvent such as, for example, ethyl lactate, a glycol ether such a 2-methoxyethyl ether (diglyme), ethylene glycol monomethyl ether, propylene glycol monomethyl ether; a Cellosolve ester such as methyl ethyl ketone; and 3-ethoxy ethyl propionate. Typically, the solids content of the composition varies between about 5 and 35 percent by weight of the total weight of the photoresist composition. The resin binder and PAG components should be present in amounts sufficient to provide a film coating layer and formation of good quality latent and relief images.

The compositions of the invention are used in accordance with generally known procedures. The liquid coating compositions of the invention are applied to a substrate such as by spinning, dipping, roller coating or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon or silicon dioxide wafers for the production of microprocessors and other integrated circuit components. Aluminum-aluminum oxide, gallium arsenide, ceramic, quartz or copper substrates also may be employed. Substrates used for liquid crystal display and other flat panel display applications are also suitably employed, e.g. glass substrates, indium tin oxide coated substrates and the like.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, the exposure energy typically ranges from about 1 to 300 mJ/cm², dependent upon the exposure tool and the components of the photoresist composition.

Coating layers of the resist compositions of the invention are preferably photoactivated by an exposure wavelength in the deep UV range i.e., 350 nm or less, more typically in the range of about 300 nm or less, typically about 150 to 300 or 450 nm. Particularly preferred exposures wavelength include 248 nm and 193 nm.

Following exposure, the film layer of the composition is preferably baked at temperatures ranging from about 70° C to about 150° C. Thereafter, the film is developed. The exposed resist film is rendered positive working by employing a polar developer, preferably an aqueous based developer such as an inorganic alkali exemplified by sodium hydroxide, potassium hydroxide, sodium carbonate, sodium bicarbonate, sodium silicate, sodium metasilicate, quaternary ammonium hydroxide solutions such as a tetra-alkyl ammonium hydroxide solution; various amine solutions such as ethyl amine, n-propyl amine, diethyl amine, di-n-propyl amine, triethyl amine, or methyldiethyl amine; alcohol amines such as diethanol amine or triethanol amine; cyclic amines such as pyrrole, pyridine, etc. In general, development is in accordance with art recognized procedures.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a chlorine or fluorine-based etchant such a CF₄ or CF₄/CHF₃ etchant applied as a plasma stream. After such processing, resist may be removed from the processed substrate using known stripping procedures.

All documents mentioned herein are fully incorporated herein by reference. The following non-limiting examples are illustrative of the invention.

### General Comments

Polymerizations were carried out with 2,2'-azobis(2,4-dimethylpentanenitrile) (Vazo52) or 2,2'-azobisisobutyronitrile (AIBN).

Polymer dissolution rates (DR) were determined by single point DRM formulating 18 % solids and 0.5 % surfactant (silylated alkoxy compound) in ethyl lactate. These solutions were spin-coated on silicon and developed in 0.26N tetrabutylammonium hydroxide aqueous developer at 23° C. Rₘᵢₙ values were determined by thickness differences at different development times, while the Rₘₐₓ values were run on the DRM after 100 mJ flood exposure (HTG scanning wedge) and a 90 second post-exposure bake (130° C). All soft bakes were for 60 seconds on a 90°C or 130°C vacuum hot plate.

Example 1: Synthesis of 1,4-cyclohexanedimethanol divinyl ether (CHVE) Crosslinked Hydroxystyrene (HS)/Styrene/*t*-butylacrylate terpolymer

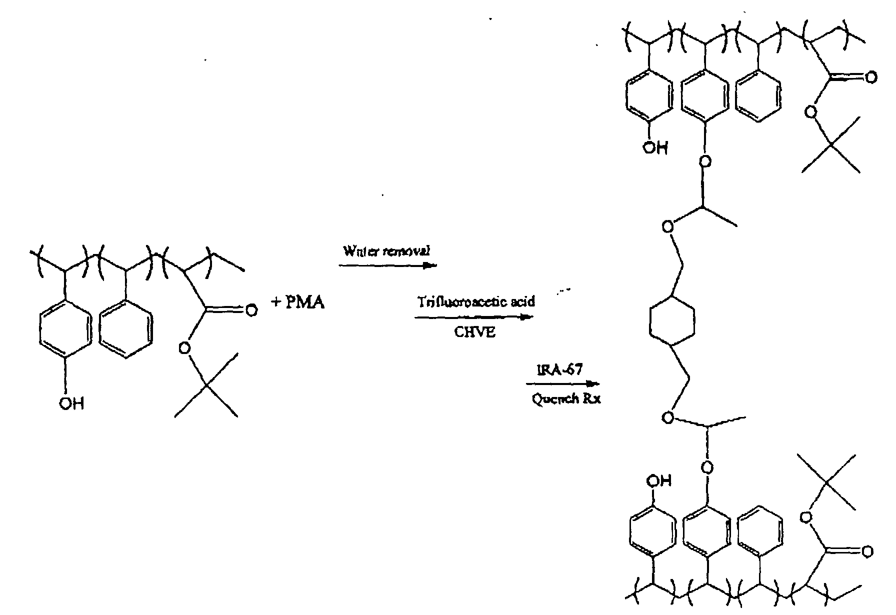

### 1 mole% (CHVE) Crosslinked Hydroxystyrene (HS)/Styrene/t-butylacrylate Terpolymer:

A 22.4 W/W% HS/Sty/tBA (65/20/15 mole%) /propylene glycol monomethylether acetate (PMA) solution was added to a flask equipped with a heating mantle, mechanical stirrer, a short path distillation col., and a vacuum aspirator. The reaction mixture was degassed for one hour at 20° C/50 torr (full aspirator vacuum). The polymer solution was then heated to 67° C *in* order to distill water/PMA azeotrope (vapor temp./pres.= 58° C/ 50 torr). Approximately 209 g of PMA/water was distilled. Karl Fisher water analysis indicated less than 0.1 % water. Percent solids (30.9 %) was calculated by mass balance.

The hydroxystyrene/styrene/t-butylacrylate (HS/Sty/tBA) PMA solution 157.96 g (30.9% solids) was charged to a 300 ml RB flask equipped with nitrogen inlet and a magnetic stirrer. A solution of trifluoroacetic acid (71 mg in 1 g PMA) was added to reaction mixture and stirred for 10 min at 20° C. Then a solution of 0.1832 g of 1,4-cyclohexanedimethaol divinyl ether (CHVE) in 1 g of PMA was added to the reaction mixture then stirred at 20° C for 19 hours. The acid catalyst was removed by stirring the reaction mixture with 50 g of PMA conditioned IRA-67 ion exchange beads for two hours. The beads were filtered off then utilizing a filter cloth. The resulting polymer had a Mw of 17,200, a Mn of 4,561, and a PD of 3.78. Percent solids (30.9 %) was determined by mass balance.

| X-linked HS/Sty/tBA | | | |
|---|---|---|---|
| Mole % CHVE | Mw | Mn | PD |
| 0.5 | 12,388 | 4,601 | 2.69 |
| 1.0 | 17,200 | 4,561 | 3.78 |
| 2.0 | 51,012 | 5,545 | 9.19 |
| 1.0 | 16,591 | 6,223 | 2.67 |

### Example 2: Synthesis of additional polymers of the invention.

A 16% (by weight) solution of the pHS/tBA copolymer (85 mole % p-hydroxystyrene/15 mole % t-butylacrylate units, Mw = 10,000) was made in PMA (propylene glycol monomethylether acetate) by polymerization of the corresponding monomers. Water in the copolymer was removed by azeotropic distillation using aspiration. PMA was added to the azeotroped copolymer solution to make up a 16% solution. To 135 g of this copolymer solution was added 16.9 g of PMA along with 69 mg TFA (trifluoroacetic acid) and the solution stirred for approximately 0.5 hours. CHVE, 1.965 g (1,4-cyclohexanedimethanoldivinylether) was then added and the solution stirred for approximately 20 hours. The residual TFA was neutralized by stirring the cross-linked copolymer solution with IRA-67 beads and filtering the solution. An additional four polymers were prepared under the same conditions, including use as a starting material a pHS/tBA copolymer that was 85 mole % p-hydroxystyrene/15 mole % t-butylacrylate.

### Example 3: Photoresist preparation and lithographic processing.

Cross-linked resins prepared in Example 2 above were each formulated into separate photoresist compositions by admixture with a photoacid generator and ethyl lactate solvent The formulated photoresists were each spin coated onto silicon wafer substrates; solvent removed on a vacuum hotplate (soft bake); the resist layers flood exposed to 248 nm radiation; each exposed resist layer was subjected to post-exposure thermal treatment; and then the resist layer treated with aqueous alkaline developer solution. Rₘᵢₙ and Rₘₐₓ values were determined. The Table below summarizes the composition of each of the resists, processing conditions (identified as softbake/post-exposure bake temperatures in degrees centigrade), and the measured Rₘᵢₙ and Rₘₐₓ values. In the Table below, "DTPSCS" desingates di-(tolyloctyloxyphenyl)sulfonium camphor sulfonate, and DTBICS designates di-(t-butylphenyl)iodonium camphorsulfonate.

**Table**

| Data Summary for Crosslinked Copolymers | | | | | |
|---|---|---|---|---|---|
| Composition HS/tBA | % X-Linking | Photoacid generator | Processing Conditions | Rₘᵢₙ^{d} | Rₘₐₓ^{e} |
| 85/15 | 5 | DTPSCS^{a} | 90/110 | 2 | 20,900 |
| 85/15 | 5 | DTBICS^{b} | 90/110 | 3 | 23,700 |
| 85/15 | 5 | DTBICS^{b} | 130/130 | 4 | 21,800 |
| 80/20 | 4 | DTBICS^{c} | 130/130 | 1^{f} | 23,000 |

a. 11% solids; b, 13% solids; c, 16% solids; d, Rₘᵢₙ determined by thickness difference at 60 and 120 second develop; c, Rₘₐₓ determined by flood exposing wafer at 100 mJ/cm² dose; f, Rₘᵢₙ determined by thickness difference at 120 and 180 second develop.

The foregoing description of the invention is merely illustrative thereof, and it is understood that variations and modification can be made without departing from the spirit or scope of the invention as set forth in the following claims.

## Claims

**1.** A positive photoresist composition comprising a photoactive component and a polymer that comprises 1) groups crosslinked or reactive to crosslinking; and 2) non-aromatic photoacid-labile groups, with at least a portion of the groups 1) crosslinked to other polymer units.

**2.** The photoresist of claim 1 wherein the polymer comprises phenolic units.

**3.** The photoresist of claim 2 wherein at least a portion of phenolic units are covalently linked to other phenolic units, either of the same polymer chain or of a separate polymer chain.

**4.** The photoresist of claim 1 wherein the polymer comprises acrylate photoacid labile groups.

**5.** The photoresist of claim 1 wherein the photoacid labile groups comprise acrylate esters that comprises a tertiary non-cyclic alkyl group or a secondary or tertiary alicyclic group.

**6.** The photoresist of claim 5 wherein the photoacid acrylate esters comprise tert-butyl, adamantyl, or norbornyl groups.

**7.** The photoresist of claim I wherein the polymer comprises 1) phenolic units, at least of portion of which in crosslinked form; 2) photoacid labile groups; 3) groups that are unreactive to lithographic processing conditions.

**8.** The photoresist of claim 7 wherein groups 3) are nitrile groups, optionally substituted phenyl groups, or optionally substituted alicyclic groups.

**9.** The photoresist of claim 1 wherein the polymer is substantially free of aromatic groups.

**10.** The photoresist of claim 1 wherein polymer units are crosslinked by a separate crosslinker component.

**11.** The photoresist of claim 10 wherein prior to reaction with the polymer the crosslinker component is an unsaturated compound.

**12.** The photoresist of claim 10 wherein prior to reaction with the polymer the crosslinker component is a vinyl ether.

**13.** The photoresist of claim 10 wherein prior to reaction with the polymer the crosslinker component is a divinyl ether.

**14.** The photoresist of claim 10 wherein prior to reaction with the polymer the crosslinker component is 1,4-butanedivinyl ether, 1,6-hexanedivinyl ether, 1,4-cyclohexane dimethanoldivinyl ether or bis-vinylether-ethane ether.

**17.** A method for forming a photoresist relief image, comprising:
a) applying a layer of a photoresist composition of claim 1 on a substrate; and
b) exposing and developing the photoresist layer on the substrate to yield a photoresist relief image.

**18.** The method of claim 17 wherein the substrate is a microelectronic wafer or a flat panel display substrate.

**19.** The method of claim 17 wherein the photoresist layer is exposed to patterned radiation having a wavelength of about 248 nm.

**20.** The method of claim 17 wherein the photoresist layer is exposed to patterned radiation having a wavelength of less than 200 nm.

**21.** A method for preparing a photoresist composition, comprising
a) admixing 1) a crosslinker component and 2) a polymer that comprises i) groups reactive to cross-linking; and ii) non-aromatic photoacid-labilc groups, to provide a crosslinked polymer; and
b) adding a photoactive component to the crosslinked polymer to provide a photoresist composition.

**22.** The method of claim 21 wherein the photoresist composition is prepared without isolation of the crosslinked polymer in a).

**23.** An article of manufacture comprising a substrate having coated thereon a photoresist composition of claim 1.

**24.** An article of claim 22 wherein the substrate is a microelectronic wafer or a flat panel display substrate

**25.** A polymer that comprises 1) groups crosslinked or reactive to cross-linking; and 2) non-aromatic photoacid-labile groups, with at least a portion of the groups 1) crosslinked to other polymer units.

**26.** The polymer of claim 25 wherein the polymer comprises phenolic units and acrylate acid labile units.

**27.** The polymer of claim 25 wherein the polymer is a terpolymer that comprises 1) phenolic units, at least of portion of which in crosslinked form; 2) non-aromatic photoacid labile groups; 3) groups that are unreactive to lithographic processing conditions.
